# FASCICULE DE BREVET EUROPEEN

(11) **EP 3 316 431 B1**
(45) Date de publication et mention de la délivrance du brevet: **07.04.2021**
(21) Numéro de dépôt: 17194599.1
(22) Date de dépôt: 03.10.2017
(51) Int. Cl.: H02H 9/04, H01L 23/34, H02H 9/06

(54) **ENROBAGE D'UN COMPOSANT INTEGRANT UNE VARISTANCE THERMOPROTEGEE ET UN ECLATEUR EN SERIE**
KAPSELUNG EINES BAUTEILS, WELCHES EINEN THERMISCH GESCHÜTZTEN VARISTOR UND EINE FUNKENSTRECKE IN SERIE BEEINHALTET
EMBEDDING OF A COMPONENT INTEGRATING A THERMALLY PROTECTED VARISTOR AND A SPARK GAP IN SERIES

(30) Priorité: 10.10.2016 FR 1659757
(43) Date de publication de la demande: 02.05.2018
(73) Titulaire: CITEL, 92310 Sèvres (FR)
(72) Inventeur: CREVENAT, Vincent, Pembroke Pines, FL 33024 (US)
(74) Mandataire: Loyer & Abello

(56) Documents cités:
- EP-A1- 1 187 290
- WO-A1-2013/097590
- CN-B- 103 346 547
- CN-U- 203 166 496
- DE-A1- 3 834 514

## Description

### Domaine technique :

L'invention se rapporte au domaine des composants intégrés de protection contre les surtensions pour un équipement électrique.

### Arrière-Plan technologique :

Pour la protection d'un équipement électrique, il est d'usage d'utiliser, entre les deux lignes d'un secteur alternatif, une varistance à oxyde métallique, notamment à oxyde de zinc, montée en série d'une part avec un élément thermofusible de déconnexion, et d'autre part avec un éclateur à gaz.

Un tel dispositif fonctionne théoriquement de la manière suivante : l'éclateur à gaz supporte pratiquement toute la tension alternative du secteur. En effet, la capacité parasite de l'éclateur est de quelques picofarads alors que la capacité parasite de la varistance est de quelques nanofarads. Lorsque survient une surtension, elle provoque l'amorçage de l'éclateur à gaz, qui ne peut s'éteindre que si le courant, dit de suite, qui le traverse ultérieurement devient suffisamment faible. C'est la résistance de la varistance qui assure la limitation du courant de suite et permet l'extinction de l'éclateur à gaz.

Lorsqu'un dispositif de protection contre les surtensions a fonctionné un certain nombre de fois, ses composants arrivent en fin de vie. Pour une varistance, la fin de vie se traduit par une explosion en l'absence de déconnexion.

Dans le cas où l'éclateur à gaz arrive le premier en fin de vie, il se mettra en court-circuit, qui se traduit par un passage en faible impédance. La varistance traversée dans cette condition par un courant subira une élévation de température suffisante pour provoquer la fusion de l'élément thermofusible, c'est-à-dire la déconnexion du circuit et la mise hors service du dispositif de protection.

Dans le cas où c'est la varistance qui atteint sa fin de vie en premier, l'éclateur permet que la varistance soit encore traversée par un courant. La varistance subit alors également une élévation de température menant à la déconnexion thermique.

L'éclateur peut également subir une élévation de température contribuant à la déconnexion thermique.

Cependant, les dispositifs de protection associant des varistances et des éclateurs sont volumineux et encombrants.

CN203166496 divulgue un composant intégré contre les surtensions qui comporte des pattes conductrices, un éclateur à gaz, une varistance et un déconnecteur thermique qui se situe entre une patte conductrice et une électrode de varistance.

EP1187290 divulgue un dispositif de protection contre les surtensions qui comporte, entre les deux lignes du secteur, un éclateur à gaz, une varistance et un élément thermofusible chargé d'assurer la déconnexion thermique du dispositif.

### Résumé de l'invention :

Une idée à la base de l'invention est d'associer les trois fonctions suivantes: varistance, protection thermique et éclateur, pour en faire un seul composant intégré discret apte à protéger un équipement électrique.

Il existe de nombreux équipements susceptibles d'être protégés par le composant intégré. Par exemple, les équipements électroniques, les systèmes téléphoniques et informatiques, les équipements photovoltaïques, les équipements d'éclairage à LEDs et autres.

Un des avantages de l'invention est de faciliter l'installation de ces trois fonctions sur une carte électronique associée à l'équipement à protéger contre les surtensions provisoires.

Un autre avantage est de permettre l'homogénéité de l'élévation de température dans le composant intégré afin d'améliorer la fiabilité de la déconnexion thermique.

Selon un mode de réalisation, l'invention fournit un composant intégré tel que défini dans la revendication 1 ou 3.

Selon un mode de réalisation, la seconde connexion est réalisée par une brasure thermofusible constituant le déconnecteur thermique.

Selon un mode de réalisation, l'électrode de l'éclateur est directement soudée sur une électrode de la varistance.

Selon des modes de réalisation, un tel composant intégré comporte une ou plusieurs des caractéristiques suivantes :
Dans un mode de réalisation, l'isolant est une plaquette en verre, en céramique ou en plastique.

Il existe de nombreuses formes de plaquette convenant à la mise en oeuvre de l'invention. Dans un mode de réalisation, la plaquette est percée d'un trou traversant et la seconde extrémité du connecteur métallique est soudée par une soudure à la première électrode de varistance à travers le trou. Dans un mode de réalisation, la plaquette présente une gouttière de sorte à ce que le métal fondu du connecteur s'introduise dans la gouttière afin que la déconnexion électrique soit fiable.

Dans un mode de réalisation, une première surface de la plaquette est fixée sur la surface de la première électrode de varistance, la première extrémité du connecteur métallique repose sur une seconde surface de la plaquette, et la seconde extrémité du connecteur métallique fait saillie hors de la seconde surface de la plaquette. Dans un mode de réalisation, le corps et la première extrémité du connecteur métallique reposent sur la seconde surface de la plaquette tandis que la seconde extrémité du connecteur métallique fait saillie hors de la seconde surface de la plaquette.

Dans un mode de réalisation, le connecteur métallique est une tige métallique comportant un corps et les deux extrémités.

Dans un mode de réalisation, le corps de la tige métallique est dans une gaine thermorétractable, de sorte à ce que, lors d'une élévation de température, l'extrémité de la tige métallique qui est soudée à la première électrode de varistance soit arrachée par la force exercée par la gaine thermorétractable sur le corps de la tige métallique.

Dans un mode de réalisation, dans lequel le connecteur métallique est apte à fondre lors d'une élévation de température supérieure à la température de fusion du connecteur métallique ; et dans lequel une portion de la première électrode de varistance est recouverte par un matériau thermoactif, le matériau thermoactif étant apte à fondre lors d'une élévation de température inférieure à la température de fusion du connecteur métallique, et étant apte à augmenter le coefficient d'étalement du connecteur électrique à l'état liquide sur la première électrode de la varistance de telle sorte que le connecteur électrique se transforme en une pellicule métallique s'étalant sur la première électrode de la varistance lors d'une élévation de température supérieure à la température de fusion du connecteur métallique.

Dans un mode de réalisation, la varistance thermoprotégée est intégralement recouverte du matériau thermoactif.

Selon un mode de réalisation, le matériau thermofusible comporte du polyamide.

Les soudures réalisées entre n'importe quelle paire d'éléments du composant sélectionnés parmi les pattes conductrices, les électrodes d'éclateur ou le connecteur métallique sont des soudures conductrices d'électricité.

Dans un mode de réalisation préféré le déconnecteur thermique est une brasure thermofusible réalisée en métal qui est soudée par son propre matériau fondu.

Dans un mode de réalisation, la brasure thermofusible est réalisée en un alliage à base d'étain pouvant comporter différents autres métaux tels que le bismuth, l'argent ou le cuivre, la température de fusion étant sélectionnée en variant la composition de l'alliage. Dans un mode de réalisation préféré, la brasure thermofusible est constituée d'un alliage d'étain « basse température » de température de fusion comprise entre 112°C et 130°C, préférentiellement entre 112°C et 118°C.

Selon un mode de réalisation, le corps de varistance est réalisé en oxyde métallique.

Selon un mode de réalisation, l'éclateur est un éclateur à gaz, également appelé en anglais « gas discharge tube (GDT) ».

Dans un mode de réalisation, le composant comporte en outre un enrobage comportant une résine protectrice, l'enrobage étant agencé autour de la varistance, du déconnecteur thermique et de l'éclateur de sorte à former une barrière protectrice isolante électriquement, seule une partie de chacune des deux pattes conductrices faisant saillie hors de l'enrobage.

Dans un mode de réalisation, la résine protectrice comporte une résine époxy.

Dans un mode de réalisation, le circuit électrique est un circuit imprimé, également désigné par « carte électronique ». Dans un mode de réalisation, le circuit électrique est un circuit électronique, également appelé en anglais « printed circuit board » (PCB).

Selon un mode de réalisation, la varistance est sélectionnée parmi le groupe comprenant une varistance de forme circulaire, une varistance de forme rectangulaire et une varistance de forme carrée.

A titre d'exemple, la varistance est sélectionnée parmi le groupe comprenant une varistance 34x34mm, une varistance 34x44mm et une varistance 34x52mmm. L'épaisseur de la varistance dépend de la tension de fonctionnement nominale maximale. Cette tension nominale de fonctionnement peut varier de quelques dizaines de volts à plusieurs centaine de volts.

Selon un mode de réalisation, la varistance est une varistance à oxyde de zinc (ZnO).

Selon un mode de réalisation non couvert par l'invention, un système électrique comporte une carte électronique et un composant intégré de protection tel que décrit ci-dessus, la carte électronique présentant deux pistes électriques connectées électriquement entre elles par l'intermédiaire du composant intégré.

L'invention fournit également un procédé de fabrication tel que défini dans la revendication 8 ou 9.

### Description brève des figures :

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.

Sur ces dessins :
La figure 1 est une vue de face d'un composant selon un premier mode de réalisation, lorsqu'il n'est pas enrobé.
La figure 2 est une vue arrière du composant de la figure 1.
La figure 3 est une vue de côté du composant de la figure 1.
La figure 4 est un schéma électrique du composant de la figure 1.
La figure 5 est une vue en perspective du composant de la figure 1, lorsqu'il est enrobé.
La figure 6 est une vue de face d'un composant selon un second mode de réalisation, lorsqu'il n'est pas enrobé.
La figure 7 est une vue de côté du composant de la figure 6.
La figure 8 est un schéma électrique du composant de la figure 6.
La figure 9 est une vue en perspective du composant de la figure 6, lorsqu'il est enrobé.
La figure 10 est un schéma électrique d'un troisième mode de réalisation non couvert par l'invention.

### Description détaillée de l'invention :

Un composant discret destiné à être monté sur un circuit électrique imprimé et permettant de protéger un équipement électrique contre les surtensions va maintenant être présenté en référence aux figures.

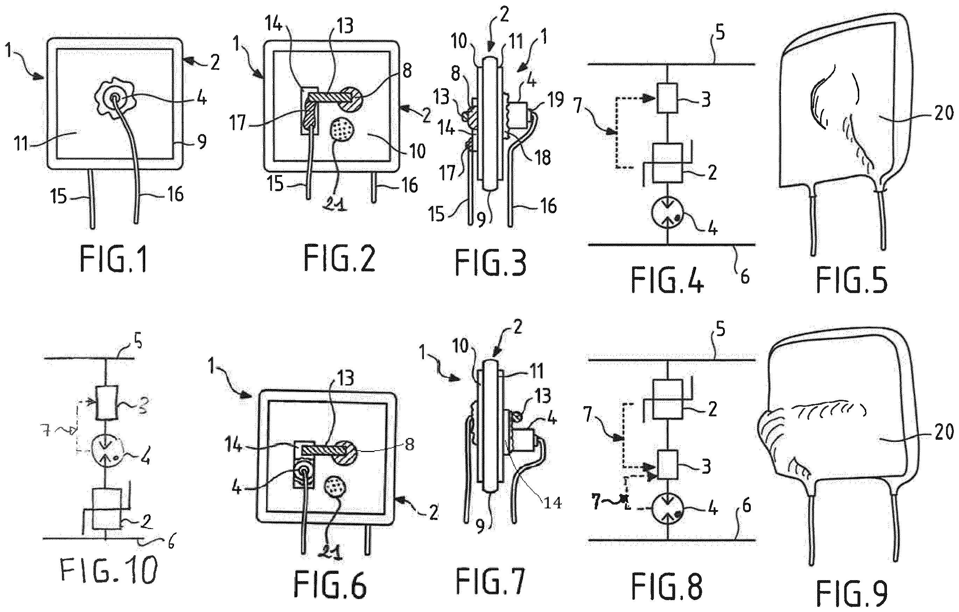

Trois modes de réalisation alternatifs d'un tel composant discret vont être présentés. Le premier mode de réalisation est représenté en référence aux figures 1 à 5. Le second mode de réalisation est représenté en référence aux figures 6 à 9. Le troisième mode de réalisation est représenté en référence à la figure 10. Les éléments identiques ou semblables sont référencés par le même chiffre de référence sur les figures représentant les deux modes de réalisation.

La figure 4 représente un schéma électrique équivalent du composant 1 selon le premier mode de réalisation. Le circuit comporte un éclateur 4, une varistance 2 et un déconnecteur thermique 3 montés en série entre deux lignes électriques 5 et 6 du circuit ou équipement électrique à protéger. Les lignes électriques 5 et 6 peuvent être tout conducteur servant à amener de l'énergie électrique sous une tension basse ou moyenne à un équipement électrique. Le déconnecteur thermique 3 est connecté à la ligne électrique 5 et à la varistance 2. Un pont thermique 7 permet de diffuser la chaleur émise par la varistance 2 vers le déconnecteur thermique 3.

L'éclateur 4 est connecté à la varistance 2 et à la ligne électrique 6 devant être protégée.

Un composant discret 1 intégrant les trois fonctions suivantes : éclateur 4, varistance 2 et déconnecteur thermique 3 ainsi qu'un procédé de fabrication de ce composant discret selon le premier mode de réalisation vont être décrit en référence aux Figures 1, 2, 3 et 5.

Un tel composant discret 1 comporte une varistance 2, par exemple une varistance de forme rectangulaire, comprenant une galette d'oxyde de zinc 9 rectangulaire et deux électrodes 10 et 11 également rectangulaires placées de part et d'autre de la galette d'oxyde de zinc 9.

Le composant comporte également un éclateur à gaz 4 comportant deux électrodes. De préférence, l'éclateur à gaz 4 est de petites dimensions, par exemple un éclateur à gaz de référence BB ou BH ou BG600 de la marque CITEL convient à l'invention.

Le composant 1 comporte également une galette isolante 14, par exemple en plastique, de dimensions largement inférieure aux dimensions de l'électrode 10, par exemple d'un dixième de la surface rectangulaire de l'électrode 10.

Le composant 1 comporte également un barreau thermofusible 13 conducteur d'électricité, de préférence en métal, par exemple en étain.

Le composant 1 comporte aussi deux pattes électriques 15 et 16.

La fabrication d'un tel composant 1 est aisée et peut être industrialisée et effectuée en série.

La fabrication d'un tel composant 1 comporte notamment l'étape de souder une des extrémités du barreau thermofusible 13 sur l'électrode 10 par une soudure 8 réalisée avec la matière du barreau thermofusible 13.

Une face de la galette isolante 14 est alors positionnée sur l'électrode 10. Optionnellement, une étape de collage de la face de la galette isolante 14 sur l'électrode 10 peut être prévue.

La fabrication comporte également une étape de fixation de l'autre extrémité du barreau thermofusible 13 sur l'autre face de la galette isolante 14, de sorte à ce que le barreau thermofusible ne soit en contact électrique avec la varistance que par son extrémité soudée à l'électrode 10.

La fabrication comporte également une étape de soudure 18 entre une première électrode d'éclateur et l'électrode 11, et une autre de soudure 17 entre la patte 15 et l'extrémité du barreau thermofusible 13 posée sur la galette isolante 14.

Il faut également réaliser une soudure 19 entre la patte 16 et une seconde électrode d'éclateur.

Puis, la fabrication du composant comporte une étape consistant à disposer en une zone de la surface de l'électrode 10 un matériau thermoactif 21.

Ce matériau thermoactif 21 est thermofusible et présente des propriétés chimiques agressives, de sorte à ce qu'il nettoie et purifie des impuretés une surface sur laquelle il fond.

Le matériau thermoactif est par exemple un matériau sélectionné parmi les matériaux suivants :
- Flux sans nettoyage, également appelé en anglais "No Clean (NC)", composé de résine, de solvant et d'une petite quantité d'activateur. Un tel flux est non-conducteur.
- Flux soluble dans l'eau, également appelé en anglais flux « Water Soluble (WS) », composé d'acides organiques, de thixotropes et de solvants.
- Flux de colophane légèrement activé, également appelé en anglais « Rosin Mildly Activated (RMA) », composé de résine, de solvant, et d'une petite quantité d'activateur. Un tel flux est non-conducteur.
- Flux de colophane activé, également appelé en anglais « Rosin Activated (RA) », constitué de résine, de solvant et d'activateurs agressifs.

Enfin, pour protéger le composant 1 ainsi obtenu, il est avantageux de recouvrir la varistance 2, l'éclateur 4 et le barreau thermofusible 13 ensembles par un enrobage de résine 20 (voir figure 5), seule une extrémité destinée à être montée sur un circuit imprimé de chacune des pattes 15, 16 faisant saillie hors de l'enrobage.

Le fonctionnement d'un tel composant lors d'une surtension provisoire, par exemple provoquée par la foudre, entre les lignes 5 et 6 va être décrit. La surtension amorce l'éclateur 4. En effet, l'éclateur 4 passe de l'état de très haute impédance au quasi court-circuit lors de l'application d'une tension supérieure à un seuil de tension entre la ligne électrique 5 et la ligne électrique 6.

Par ailleurs, cette surtension induit un courant qui traverse la varistance. Le courant traversant la varistance 2 induit alors un échauffement progressif de la varistance 2 et donc l'échauffement du déconnecteur thermique 3 par l'intermédiaire du pont thermique 7 entre la varistance et le déconnecteur thermique 3. Lorsque la surtension dépasse le seuil de tension nominal de la varistance 2, la varistance 2 passe en faible impédance et limite la tension à ses bornes. Le composant discret est donc bien apte à protéger la ligne électrique 5 de la surtension imposée.

Cependant, au-delà d'un plafond d'échauffement correspondant à une température de déconnexion du déconnecteur thermique, le courant induit est brusquement interrompu par le déconnecteur thermique 3.

Ce déconnecteur thermique 3 comporte le barreau thermofusible 13 ainsi que le matériau thermoactif 21.

La déconnexion permise par le barreau thermofusible 13 et le matériau thermoactif 21 va à présent être décrite plus en détail.

L'échauffement induit sur le matériau thermoactif 21 a pour conséquence que le matériau fond et coule sur la surface de la première électrode 10 de sorte à nettoyer et purifier la surface de la première l'électrode 10.

L'échauffement induit sur le barreau thermofusible 13 par le pont thermique 7 va également provoquer sa fonte, ultérieurement à celle du matériau thermoactif 21 dont la température de fusion est inférieure. La matière fondue du barreau forme alors une goutte qui glisse et s'étale sur la surface de la première électrode 10. En effet, le nettoyage produit par le matériau thermoactif 21 fondu sur la surface de la première électrode de varistance 10 a permis d'augmenter la mouillabilité de l'étain sur la surface de la première électrode de varistance 10. En conséquence, l'étain fondu du barreau thermofusible 13 forme une fine pellicule de métal sur la totalité de la surface de la première électrode de varistance 10. Cette fine pellicule n'est plus à même d'assurer la connexion électrique entre la première électrode de varistance et la première patte conductrice 15.

L'intensité du courant devient donc nulle.

Ainsi, le composant 1 est apte à protéger la ligne électrique 5 des incendies en la déconnectant totalement lors d'une élévation de température au-delà d'un seuil de température.

En référence aux figures 6 à 9, un second mode de réalisation du composant discret selon l'invention va être exposé. Les éléments similaires ou semblables aux figures du premier mode de réalisation sont identifiés par les mêmes chiffres de référence.

La figure 8 représente un schéma électrique équivalent du composant 1 selon le second mode de réalisation. Le circuit comporte, comme dans le premier mode de réalisation, un éclateur 4, une varistance 2 et un déconnecteur thermique 3 montés en série sur une ligne électrique à protéger. Contrairement au premier mode de réalisation, le déconnecteur thermique 3 est agencé entre la varistance 2 et l'éclateur 4.

La varistance 2 est connectée à la ligne électrique 5 devant être protégée et au déconnecteur thermique 3. Un pont thermique 7 permet de diffuser la chaleur émise par la varistance 2 et l'éclateur 4 vers le déconnecteur thermique 3. L'éclateur 4 est connecté au déconnecteur thermique 3 et à une seconde ligne électrique 6 devant être protégée.

Un procédé de fabrication du composant discret selon le second mode de réalisation, intégrant les trois fonctions suivantes : éclateur 4, varistance 2 et déconnecteur thermique 3 va être décrit en référence aux Figures 6 à 9. Le composant discret selon ce second mode de réalisation comporte les mêmes éléments que le composant selon le premier mode de réalisation. Seul le procédé de fabrication diffère pour quelques étapes.

La fabrication du composant 1 comporte notamment l'étape de souder une des extrémités du barreau thermofusible 13 sur l'électrode 11 par une soudure 8.

Dans ce second mode de réalisation, une face de la galette isolante 14 est posée sur l'électrode 11, et non sur l'électrode 10. Avantageusement, cette face de la galette isolante 14 peut être collée sur l'électrode 11.

De plus, il faut fixer l'autre extrémité du barreau thermofusible 13 sur l'autre face de la galette isolante 14, de sorte à ce que le barreau thermofusible ne soit en contact électrique avec la varistance que par son extrémité soudée à l'électrode 11, et non à l'électrode 10.

Il faut également réaliser une soudure 18 entre une première électrode d'éclateur et l'extrémité du barreau thermofusible 13 posée sur la galette isolante 14.

Les pattes électriques sont également soudées différemment que dans le premier mode de réalisation. En effet, la fabrication comporte la réalisation d'une soudure 17 entre la patte 15 et l'électrode 10, et la réalisation d'une soudure 19 entre la patte 16 et une seconde électrode d'éclateur.

Un troisième mode de réalisation non couvert par les revendications est représenté sur la figure 10. La figure 10 représente un schéma électrique équivalent du composant 1 selon le troisième mode de réalisation. Le circuit comporte, comme dans le premier mode de réalisation, un éclateur 4, une varistance 2 et un déconnecteur thermique 3 montés en série sur une ligne électrique à protéger. Contrairement au premier mode de réalisation, réalisation, l'éclateur 4 est agencé entre le déconnecteur thermique 3 et la varistance 2. Dans un tel mode de réalisation, le déconnecteur thermique 3 n'est ainsi sensible qu'à un échauffement de l'éclateur 4.

Bien que l'invention ait été décrite en liaison avec deux modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention. Par exemple, on peut prévoir d'autres varistances pour fabriquer le composant. Par exemple, la varistance utilisée peut présenter des caractéristiques techniques différentes de celle présentées ci-dessus, par exemple des dimensions de 34x34mm en largeur et en longueur, une tension maximale de fonctionnement nominal de 385Volts en courant alternatif et 505Volts en courant continu, une tension en courant continu sous une intensité de 1mA entre 590 et 600Volts et un courant de décharge maximum de 40kA (8/20µs).

L'usage du verbe « comporter », « comprendre » ou « inclure » et de ses formes conjuguées n'exclut pas la présence d'autres éléments ou d'autres étapes que ceux énoncés dans une revendication. L'usage de l'article indéfini « un » ou « une » pour un élément ou une étape n'exclut pas, sauf mention contraire, la présence d'une pluralité de tels éléments ou étapes.

Dans les revendications, tout signe de référence entre parenthèses ne saurait être interprété comme une limitation de la revendication.

## Revendications

1. Composant intégré (1) de protection contre les surtensions transitoires, comportant :
• une première et une seconde pattes conductrices (15, 16) qui sont chacune aptes à être montées sur un circuit électrique ;
• un éclateur à gaz (4) comportant une première électrode d'éclateur, une seconde électrode d'éclateur et un corps d'éclateur disposé entre la première et la seconde électrodes d'éclateur, le corps de l'éclateur étant apte à monter en température lorsque qu'un courant électrique le traverse ;
• un déconnecteur thermique (3) équipé d'un élément sensible (13) à la température agencé pour assurer une connexion électrique dans un état initial et pour interrompre ladite connexion électrique lorsqu'il est soumis à une température supérieure à un seuil
• une varistance (2) comportant :
- un corps de varistance (9),
- une première électrode de varistance (10) et une seconde électrode de varistance (11) placées de part et d'autre du corps de varistance, le corps de varistance étant apte à monter en température lorsque la tension imposée entre la première et la seconde électrodes de varistance dépasse un seuil de tension;
la première patte conductrice étant connectée à la première électrode de varistance par une première connexion,
la seconde électrode de varistance étant connectée à la première électrode d'éclateur par une seconde connexion,
la seconde électrode d'éclateur étant connectée à la seconde patte conductrice par une troisième connexion,
la première connexion étant réalisée à travers le déconnecteur thermique (3), l'élément sensible à la température étant sensible à l'élévation de température d'au moins l'un parmi l'éclateur et la varistance, dans lequel l'élément sensible à la température du déconnecteur thermique (3) est un connecteur métallique (13) ayant une température de fusion égale ou inférieure à un seuil thermique de température de sécurité pour la varistance, dans lequel une première extrémité du connecteur métallique (13) est soudée sur la première électrode de varistance, le composant comportant en outre un isolant (14) disposé sur une surface de la première électrode de varistance (10) de manière à ce qu'une seconde extrémité du connecteur métallique (13) ne soit pas en contact avec la surface de la première électrode de varistance.

2. Composant intégré de protection selon la revendication 1, dans lequel le connecteur métallique (13) est apte à fondre lors d'une élévation de température supérieure à la température de fusion du connecteur métallique (13) ; et dans lequel une portion de la première électrode de varistance (10) est recouverte par un matériau thermoactif (21), le matériau thermoactif (21) étant apte à fondre lors d'une élévation de température inférieure à la température de fusion du connecteur métallique (13), et étant apte à augmenter le coefficient d'étalement du connecteur métallique (13) à l'état liquide sur la première électrode de la varistance de telle sorte que le connecteur métallique (13) se transforme en une pellicule métallique s'étalant sur la première électrode de la varistance lors d'une élévation de température supérieure à la température de fusion du connecteur métallique (13).

3. Composant intégré (1) de protection contre les surtensions transitoires, comportant :
• une première et une seconde pattes conductrices (15, 16) qui sont chacune aptes à être montées sur un circuit électrique ;
• un éclateur à gaz (4) comportant une première électrode d'éclateur, une seconde électrode d'éclateur et un corps d'éclateur disposé entre la première et la seconde électrodes d'éclateur, le corps de l'éclateur étant apte à monter en température lorsque qu'un courant électrique le traverse ;
• un déconnecteur thermique (3) équipé d'un élément sensible (13) à la température agencé pour assurer une connexion électrique dans un état initial et pour interrompre ladite connexion électrique lorsqu'il est soumis à une température supérieure à un seuil
• une varistance (2) comportant :
- un corps de varistance (9),
- une première électrode de varistance (10) et une seconde électrode de varistance (11) placées de part et d'autre du corps de varistance, le corps de varistance étant apte à monter en température lorsque la tension imposée entre la première et la seconde électrodes de varistance dépasse un seuil de tension;
la première patte conductrice étant connectée à la première électrode de varistance par une première connexion,
la seconde électrode de varistance étant connectée à la première électrode d'éclateur par une seconde connexion,
la seconde électrode d'éclateur étant connectée à la seconde patte conductrice par une troisième connexion,
la deuxième connexion étant réalisée à travers le déconnecteur thermique (3), l'élément sensible à la température étant sensible à l'élévation de température d'au moins l'un parmi l'éclateur et la varistance,
dans lequel l'élément sensible à la température du déconnecteur thermique (3) est un connecteur métallique (13) ayant une température de fusion égale ou inférieure à un seuil thermique de température de sécurité pour la varistance ou l'éclateur,
dans lequel une première extrémité du connecteur métallique (13) est soudée sur la deuxième électrode de varistance, le composant comportant en outre un isolant (14) disposé sur une surface de la deuxième électrode de varistance (11) de manière à ce qu'une seconde extrémité du connecteur métallique (13) ne soit pas en contact avec la surface de la deuxième électrode de varistance.

4. Composant intégré de protection selon la revendication 3, dans lequel le connecteur métallique (13) est apte à fondre lors d'une élévation de température supérieure à la température de fusion du connecteur métallique (13) ; et dans lequel une portion de la deuxième électrode de varistance (11) est recouverte par un matériau thermoactif (21), le matériau thermoactif (21) étant apte à fondre lors d'une élévation de température inférieure à la température de fusion du connecteur métallique (13), et étant apte à augmenter le coefficient d'étalement du connecteur métallique (13) à l'état liquide sur la deuxième électrode de la varistance de telle sorte que le connecteur métallique (13) se transforme en une pellicule métallique s'étalant sur la deuxième électrode de la varistance lors d'une élévation de température supérieure à la température de fusion du connecteur métallique (13).

5. Composant intégré de protection selon l'une quelconque des revendications 1 à 4, dans lequel l'isolant (14) est une plaquette réalisée en matière plastique, en céramique ou en verre.

6. Composant intégré de protection selon l'une quelconque des revendications 1 à 5, comportant en outre un enrobage comportant une résine protectrice, l'enrobage étant agencé autour de la varistance, du déconnecteur thermique (3) et de l'éclateur de sorte à former une barrière protectrice isolante électriquement, seule une partie de chacune des deux pattes conductrices faisant saillie hors de l'enrobage.

7. Composant intégré de protection selon la revendication 6, dans lequel la résine protectrice comporte une résine époxy.

8. Procédé de fabrication d'un composant intégré de protection contre les surtensions transitoires, comportant :
• fournir une première et une seconde pattes conductrices (15, 16) qui sont chacune aptes à être montées sur un circuit électrique;
• fournir un éclateur à gaz (4) comportant une première électrode d'éclateur une seconde électrode d'éclateur et un corps d'éclateur disposé entre la première et la seconde électrodes d'éclateur, le corps de l'éclateur étant apte à monter en température lorsque qu'un courant électrique le traverse ;
• fournir un déconnecteur thermique (3) équipé d'un élément sensible à la température agencé pour assurer une connexion électrique dans un état initial et pour interrompre ladite connexion électrique lorsqu'il est soumis à une température supérieure à un seuil;
• fournir une varistance (2) comportant :
- un corps de varistance (9),
- une première électrode de varistance (10) et une seconde électrode de varistance (11) placées de part et d'autre du corps de varistance, le corps de varistance étant apte à monter en température lorsque la tension imposée entre la première et la seconde électrodes de varistance dépasse un seuil de tension ;
- réaliser une première connexion électrique entre la première patte conductrice et la première électrode de varistance,
- réaliser une seconde connexion électrique entre la première électrode d'éclateur et la seconde électrode de varistance,
- réaliser une troisième connexion électrique entre la seconde électrode d'éclateur et la seconde patte conductrice,
- l'une parmi les première et seconde connexions électriques étant réalisée via le déconnecteur thermique (3),
- l'élément sensible à la température du déconnecteur thermique (3) étant un connecteur métallique (13) ayant une température de fusion égale ou inférieure à un seuil thermique de température de sécurité pour la varistance,
- souder une première extrémité du connecteur métallique (13) sur la première électrode de varistance,
- fournir un isolant (14) sur le composant, l'isolant (14) étant disposé sur une surface de la première électrode de varistance (10) de manière à ce qu'une seconde extrémité du connecteur métallique (13) ne soit pas en contact avec la surface de la première électrode de varistance.

9. Procédé de fabrication d'un composant intégré de protection contre les surtensions transitoires, comportant :
• fournir une première et une seconde pattes conductrices (15, 16) qui sont chacune aptes à être montées sur un circuit électrique;
• fournir un éclateur à gaz (4) comportant une première électrode d'éclateur une seconde électrode d'éclateur et un corps d'éclateur disposé entre la première et la seconde électrodes d'éclateur, le corps de l'éclateur étant apte à monter en température lorsque qu'un courant électrique le traverse ;
• fournir un déconnecteur thermique (3) équipé d'un élément sensible à la température agencé pour assurer une connexion électrique dans un état initial et pour interrompre ladite connexion électrique lorsqu'il est soumis à une température supérieure à un seuil;
• fournir une varistance (2) comportant :
- un corps de varistance (9),
- une première électrode de varistance (10) et une seconde électrode de varistance (11) placées de part et d'autre du corps de varistance, le corps de varistance étant apte à monter en température lorsque la tension imposée entre la première et la seconde électrodes de varistance dépasse un seuil de tension ;
- réaliser une première connexion électrique entre la première patte conductrice et la première électrode de varistance,
- réaliser une seconde connexion électrique entre la première électrode d'éclateur et la seconde électrode de varistance,
- réaliser une troisième connexion électrique entre la seconde électrode d'éclateur et la seconde patte conductrice,
- la seconde connexion électrique étant réalisée via le déconnecteur thermique (3),
- l'élément sensible à la température du déconnecteur thermique (3) étant un connecteur métallique (13) ayant une température de fusion égale ou inférieure à un seuil thermique de température de sécurité pour la varistance ou l'éclateur,
- souder une première extrémité du connecteur métallique (13) sur la deuxième électrode de varistance,
- fournir un isolant (14) sur le composant, l'isolant (14) étant disposé sur une surface de la deuxième électrode de varistance (10) de manière à ce qu'une seconde extrémité du connecteur métallique (13) ne soit pas en contact avec la surface de la deuxième électrode de varistance.

## Patentansprüche

1. Integriertes Bauelement (1) zum Schutz gegen transiente Überspannungen, aufweisend:
• ein erstes und ein zweites leitendes Bein (15, 16), die jeweils geeignet sind, auf einem elektrischen Schaltkreis angebracht zu sein;
• einen Gasableiter (4), der eine erste Ableiterelektrode, eine zweite Ableiterelektrode und einen Ableiterkörper, der zwischen der ersten und der zweiten Ableiterelektrode angeordnet ist, aufweist, wobei der Körper des Ableiters geeignet ist, in der Temperatur anzusteigen, wenn ihn ein elektrischer Strom durchfließt;
• einen Thermoschalter (3), der mit einem temperaturempfindlichen Element (13) ausgerüstet ist, der angeordnet ist, in einem Anfangszustand eine elektrische Verbindung sicherzustellen und die elektrische Verbindung zu unterbrechen, wenn er einer Temperatur ausgesetzt ist, die höher als eine Schwelle ist;
• einen Varistor (2) aufweisend:
- einen Varistorkörper (9),
- eine erste Varistorelektrode (10) und eine zweite Varistorelektrode (11), die beiderseits des Varistorkörpers platziert sind, wobei der Varistorkörper geeignet ist, in der Temperatur anzusteigen, wenn die Spannung, die zwischen der ersten und der zweiten Varistorelektrode angelegt ist, eine Spannungsschwelle übersteigt;
wobei das erste leitende Bein über einen ersten Anschluss an die erste Varistorelektrode angeschlossen ist,
wobei die zweite Varistorelektrode über einen zweiten Anschluss an die erste Ableiterelektrode angeschlossen ist,
wobei die zweite Ableiterelektrode über einen dritten Anschluss an das zweite leitende Bein angeschlossen ist,
wobei der erste Anschluss durch den Thermoschalter (3) hergestellt ist, wobei das temperaturempfindliche Element gegenüber dem Temperaturanstieg wenigstens eines von dem Ableiter und dem Varistor empfindlich ist,
wobei das temperaturempfindliche Element des Thermoschalters (3) ein Metallverbinder (13) mit einer Schmelztemperatur kleiner oder gleich einer Sicherheitstemperatur-Wärmeschwelle für den Varistor ist, wobei ein erstes Ende des Metallverbinders (13) an die erste Varistorelektrode gelötet ist, wobei das Bauelement ferner einen Isolator (14) aufweist, der so auf einer Fläche der ersten Varistorelektrode (10) angeordnet ist, dass ein zweites Ende des Metallverbinders (13) nicht mit der Fläche der ersten Varistorelektrode in Kontakt steht.

2. Integriertes Schutzbauelement nach Anspruch 1, wobei der Metallverbinder (13) geeignet ist, bei einem Temperaturanstieg über die Schmelztemperatur des Metallverbinders (13) zu schmelzen; und wobei ein Teilbereich der ersten Varistorelektrode (10) mit einem thermoreaktiven Material (21) bedeckt ist, wobei das thermoreaktive Material (21) geeignet ist, bei einem Temperaturanstieg unter die Schmelztemperatur des Metallverbinders (13) zu schmelzen, und geeignet ist, den Spreitungskoeffizienten des Metallverbinders (13) im flüssigen Zustand auf der ersten Elektrode des Varistors so anzuheben, dass sich der Metallverbinder (13) in einen Metallfilm verwandelt, der sich bei einem Temperaturanstieg über die Schmelztemperatur des Metallverbinders (13) auf der ersten Elektrode des Varistors ausbreitet.

3. Integriertes Bauelement (1) zum Schutz gegen transiente Überspannungen, aufweisend:
• ein erstes und ein zweites leitendes Bein (15, 16), die jeweils geeignet sind, auf einem elektrischen Schaltkreis angebracht zu sein;
• einen Gasableiter (4), der eine erste Ableiterelektrode, eine zweite Ableiterelektrode und einen Ableiterkörper, der zwischen der ersten und der zweiten Ableiterelektrode angeordnet ist, aufweist, wobei der Körper des Ableiters geeignet ist, in der Temperatur anzusteigen, wenn ihn ein elektrischer Strom durchfließt;
• einen Thermoschalter (3), der mit einem temperaturempfindlichen Element (13) ausgerüstet ist, der angeordnet ist, in einem Anfangszustand eine elektrische Verbindung sicherzustellen und die elektrische Verbindung zu unterbrechen, wenn er einer Temperatur ausgesetzt ist, die höher als eine Schwelle ist;
• einen Varistor (2) aufweisend:
- einen Varistorkörper (9),
- eine erste Varistorelektrode (10) und eine zweite Varistorelektrode (11), die beiderseits des Varistorkörpers platziert sind, wobei der Varistorkörper geeignet ist, in der Temperatur anzusteigen, wenn die Spannung, die zwischen der ersten und der zweiten Varistorelektrode angelegt ist, eine Spannungsschwelle übersteigt;
wobei das erste leitende Bein über einen ersten Anschluss an die erste Varistorelektrode angeschlossen ist,
wobei die zweite Varistorelektrode über einen zweiten Anschluss an die erste Ableiterelektrode angeschlossen ist,
wobei die zweite Ableiterelektrode über einen dritten Anschluss an das zweite leitende Bein angeschlossen ist,
wobei der zweite Anschluss durch den Thermoschalter (3) hergestellt ist, wobei das temperaturempfindliche Element gegenüber dem Temperaturanstieg wenigstens eines von dem Ableiter und dem Varistor empfindlich ist,
wobei das temperaturempfindliche Element des Thermoschalters (3) ein Metallverbinder (13) mit einer Schmelztemperatur kleiner oder gleich einer Sicherheitstemperatur-Wärmeschwelle für den Varistor oder den Ableiter ist, wobei ein erstes Ende des Metallverbinders (13) an die zweite Varistorelektrode gelötet ist, wobei das Bauelement ferner einen Isolator (14) aufweist, der so auf einer Fläche der zweiten Varistorelektrode (11) angeordnet ist, dass ein zweites Ende des Metallverbinders (13) nicht mit der Fläche der zweiten Varistorelektrode in Kontakt steht.

4. Integriertes Schutzbauelement nach Anspruch 3, wobei der Metallverbinder (13) geeignet ist, bei einem Temperaturanstieg über die Schmelztemperatur des Metallverbinders (13) zu schmelzen; und wobei ein Teilbereich der zweiten Varistorelektrode (11) mit einem thermoreaktiven Material (21) bedeckt ist, wobei das thermoreaktive Material (21) geeignet ist, bei einem Temperaturanstieg unter die Schmelztemperatur des Metallverbinders (13) zu schmelzen, und geeignet ist, den Spreitungskoeffizienten des Metallverbinders (13) im flüssigen Zustand auf der zweiten Elektrode des Varistors so anzuheben, dass sich der Metallverbinder (13) in einen Metallfilm verwandelt, der sich bei einem Temperaturanstieg über die Schmelztemperatur des Metallverbinders (13) auf der zweiten Elektrode des Varistors ausbreitet.

5. Integriertes Schutzbauelement nach einem der Ansprüche 1 bis 4, wobei der Isolator (14) ein Plättchen ist, das aus Kunststoff, Keramik oder Glas hergestellt ist.

6. Integriertes Schutzbauelement nach einem der Ansprüche 1 bis 5, ferner aufweisend eine Ummantelung, die ein schützendes Harz aufweist, wobei die Ummantelung um den Varistor, den Thermoschalter (3) und den Ableiter herum angeordnet ist, um eine elektrisch isolierende Schutzbarriere zu bilden, wobei nur ein Abschnitt jedes der zwei leitenden Beine aus der Ummantelung herausragt.

7. Integriertes Schutzbauelement nach Anspruch 6, wobei das schützende Harz ein Epoxidharz aufweist.

8. Verfahren zur Herstellung eines integrierten Bauelements zum Schutz gegen transiente Überspannungen, aufweisend:
• Bereitstellen eines ersten und eines zweiten leitenden Beins (15, 16), die jeweils geeignet sind, auf einem elektrischen Schaltkreis angebracht zu sein;
• Bereitstellen eines Gasableiters (4), der eine erste Ableiterelektrode, eine zweite Ableiterelektrode und einen Ableiterkörper, der zwischen der ersten und der zweiten Ableiterelektrode angeordnet ist, aufweist, wobei der Körper des Ableiters geeignet ist, in der Temperatur anzusteigen, wenn ihn ein elektrischer Strom durchfließt;
• Bereitstellen eines Thermoschalters (3), der mit einem temperaturempfindlichen Element ausgerüstet ist, der angeordnet ist, in einem Anfangszustand eine elektrische Verbindung sicherzustellen und die elektrische Verbindung zu unterbrechen, wenn er einer Temperatur ausgesetzt ist, die höher als eine Schwelle ist;
• Bereitstellen eines Varistors (2) aufweisend:
- einen Varistorkörper (9),
- eine erste Varistorelektrode (10) und eine zweite Varistorelektrode (11), die beiderseits des Varistorkörpers platziert sind, wobei der Varistorkörper geeignet ist, in der Temperatur anzusteigen, wenn die Spannung, die zwischen der ersten und der zweiten Varistorelektrode angelegt ist, eine Spannungsschwelle übersteigt;
- Herstellen einer ersten elektrischen Verbindung zwischen dem ersten leitenden Bein und der ersten Varistorelektrode,
- Herstellen einer zweiten elektrischen Verbindung zwischen der ersten Ableiterelektrode und der zweiten Varistorelektrode,
- Herstellen einer dritten elektrischen Verbindung zwischen der zweiten Ableiterelektrode und dem zweiten leitenden Bein,
- wobei die eine der ersten und zweiten elektrischen Verbindung über den Thermoschalter (3) hergestellt wird,
- wobei das temperaturempfindliche Element des Thermoschalters (3) ein Metallverbinder (13) mit einer Schmelztemperatur kleiner oder gleich einer Sicherheitstemperatur-Wärmeschwelle für den Varistor oder ist,
- Löten eines ersten Endes des Metallverbinders (13) an die erste Varistorelektrode,
- Bereitstellen eines Isolators (14) auf dem Bauelement, wobei der Isolator (14) so auf einer Fläche der ersten Varistorelektrode (10) angeordnet ist, dass ein zweites Ende des Metallverbinders (13) nicht mit der Fläche der ersten Varistorelektrode in Kontakt steht.

9. Verfahren zur Herstellung eines integrierten Bauelements zum Schutz gegen transiente Überspannungen, aufweisend:
• Bereitstellen eines ersten und eines zweiten leitenden Beins (15, 16), die jeweils geeignet sind, auf einem elektrischen Schaltkreis angebracht zu sein;
• Bereitstellen eines Gasableiters (4), der eine erste Ableiterelektrode, eine zweite Ableiterelektrode und einen Ableiterkörper, der zwischen der ersten und der zweiten Ableiterelektrode angeordnet ist, aufweist, wobei der Körper des Ableiters geeignet ist, in der Temperatur anzusteigen, wenn ihn ein elektrischer Strom durchfließt;
• Bereitstellen eines Thermoschalters (3), der mit einem temperaturempfindlichen Element ausgerüstet ist, der angeordnet ist, in einem Anfangszustand eine elektrische Verbindung sicherzustellen und die elektrische Verbindung zu unterbrechen, wenn er einer Temperatur ausgesetzt ist, die höher als eine Schwelle ist;
• Bereitstellen eines Varistors (2) aufweisend:
- einen Varistorkörper (9),
- eine erste Varistorelektrode (10) und eine zweite Varistorelektrode (11), die beiderseits des Varistorkörpers platziert sind, wobei der Varistorkörper geeignet ist, in der Temperatur anzusteigen, wenn die Spannung, die zwischen der ersten und der zweiten Varistorelektrode angelegt ist, eine Spannungsschwelle übersteigt;
- Herstellen einer ersten elektrischen Verbindung zwischen dem ersten leitenden Bein und der ersten Varistorelektrode,
- Herstellen einer zweiten elektrischen Verbindung zwischen der ersten Ableiterelektrode und der zweiten Varistorelektrode,
- Herstellen einer dritten elektrischen Verbindung zwischen der zweiten Ableiterelektrode und dem zweiten leitenden Bein,
- wobei die zweite elektrische Verbindung über den Thermoschalter (3) hergestellt wird,
- wobei das temperaturempfindliche Element des Thermoschalters (3) ein Metallverbinder (13) mit einer Schmelztemperatur kleiner oder gleich einer Sicherheitstemperatur-Wärmeschwelle für den Varistor oder den Ableiter ist,
- Löten eines ersten Endes des Metallverbinders (13) an die zweite Varistorelektrode,
- Bereitstellen eines Isolators (14) auf dem Bauelement, wobei der Isolator (14) so auf einer Fläche der zweiten Varistorelektrode (10) angeordnet ist, dass ein zweites Ende des Metallverbinders (13) nicht mit der Fläche der zweiten Varistorelektrode in Kontakt steht.

## Claims

1. Integrated component (1) for protecting against transient overvoltages, including:
• a first and a second conductive tab (15, 16), each of which is able to be mounted on an electrical circuit;
• a gas discharge tube (4) including a first discharge tube electrode, a second discharge tube electrode and a discharge tube body arranged between the first and the second discharge tube electrodes, the body of the discharge tube being able to rise in temperature when an electric current flows through it;
• a thermal disconnector (3) equipped with a temperature-sensitive element (13) designed to provide an electrical connection in an initial state and to interrupt said electrical connection when it is subjected to a temperature greater than a threshold;
• a varistor (2) including:
- a varistor body (9),
- a first varistor electrode (10) and a second varistor electrode (11) that are positioned on either side of the varistor body, the varistor body being able to rise in temperature when the voltage applied across the first and the second varistor electrodes exceeds a voltage threshold;
the first conductive tab being connected to the first varistor electrode by a first connection, the second varistor electrode being connected to the first discharge tube electrode by a second connection,
the second discharge tube electrode being connected to the second conductive tab by a third connection,
the first connection being made through the thermal disconnector (3), the temperature-sensitive element being sensitive to the temperature increase of at least one of the discharge tube and the varistor;
wherein the temperature-sensitive element of the thermal disconnector (3) is a metal connector (13) having a melting point equal to or less than a thermal safety temperature threshold for the varistor,
wherein a first end of the metal connector (13) is soldered to the first varistor electrode, the component furthermore including an insulator (14) arranged on a surface of the first varistor electrode (10) in such a way that a second end of the metal connector (13) does not make contact with the surface of the first varistor electrode.

2. Protective integrated component according to Claim 1, wherein the metal connector (13) is able to melt upon a temperature increase above the melting point of the metal connector (13); and wherein a portion of the first varistor electrode (10) is covered by a thermoactive material (21), the thermoactive material (21) being able to melt upon a temperature increase below the melting point of the metal connector (13), and being able to increase the coefficient of spreading of the metal connector (13) in the liquid state over the first electrode of the varistor, such that the metal connector (13) transforms into a metal film spreading over the first electrode of the varistor upon a temperature increase above the melting point of the metal connector (13).

3. Integrated component (1) for protecting against transient overvoltages, including:
• a first and a second conductive tab (15, 16), each of which is able to be mounted on an electrical circuit;
• a gas discharge tube (4) including a first discharge tube electrode, a second discharge tube electrode and a discharge tube body arranged between the first and the second discharge tube electrodes, the body of the discharge tube being able to rise in temperature when an electric current flows through it;
• a thermal disconnector (3) equipped with a temperature-sensitive element (13) designed to provide an electrical connection in an initial state and to interrupt said electrical connection when it is subjected to a temperature greater than a threshold;
• a varistor (2) including:
- a varistor body (9),
- a first varistor electrode (10) and a second varistor electrode (11) that are positioned on either side of the varistor body, the varistor body being able to rise in temperature when the voltage applied across the first and the second varistor electrodes exceeds a voltage threshold;
the first conductive tab being connected to the first varistor electrode by a first connection, the second varistor electrode being connected to the first discharge tube electrode by a second connection,
the second discharge tube electrode being connected to the second conductive tab by a third connection,
the second connection being made through the thermal disconnector (3), the temperature-sensitive element being sensitive to the temperature increase of at least one of the discharge tube and the varistor;
wherein the temperature-sensitive element of the thermal disconnector (3) is a metal connector (13) having a melting point equal to or less than a thermal safety temperature threshold for the varistor or the discharge tube,
wherein the metal connector (13) is soldered by a solder joint to at least one of the first discharge tube electrode, the second discharge tube electrode, the first varistor electrode and the second varistor electrode, so as to form one of the first, second or third connections.
wherein a first end of the metal connector (13) is soldered to the second varistor electrode, the component furthermore including an insulator (14) arranged on a surface of the second varistor electrode (11) in such a way that a second end of the metal connector (13) does not make contact with the surface of the second varistor electrode.

4. Protective integrated component according to Claim 3, wherein the metal connector (13) is able to melt upon a temperature increase above the melting point of the metal connector (13); and wherein a portion of the second varistor electrode (11) is covered by a thermoactive material (21), the thermoactive material (21) being able to melt upon a temperature increase below the melting point of the metal connector (13), and being able to increase the coefficient of spreading of the metal connector (13) in the liquid state over the second electrode of the varistor, such that the metal connector (13) transforms into a metal film spreading over the second electrode of the varistor upon a temperature increase above the melting point of the metal connector (13).

5. Protective integrated component according to any one of claims 1 to 4, wherein the insulator (14) is a plate made of plastic, of ceramic or of glass.

6. Protective integrated component according to any one of Claims 1 to 5, furthermore including a coating including a protective resin, the coating being arranged around the varistor, the thermal disconnector (3) and the discharge tube so as to form an electrically insulating protective barrier, only a portion of each of the two conductive tabs protruding beyond the coating.

7. Protective integrated component according to Claim 6, wherein the protective resin includes an epoxy resin.

8. Method for manufacturing an integrated component for protecting against transient overvoltages, including:
• providing a first and a second conductive tab (15, 16), each of which is able to be mounted on an electrical circuit;
• providing a gas discharge tube (4) including a first discharge tube electrode, a second discharge tube electrode and a discharge tube body arranged between the first and the second discharge tube electrodes, the body of the discharge tube being able to rise in temperature when an electric current flows through it;
• providing a thermal disconnector (3) equipped with a temperature-sensitive element designed to provide an electrical connection in an initial state and to interrupt said electrical connection when it is subjected to a temperature greater than a threshold;
• providing a varistor (2) including:
- a varistor body (9),
- a first varistor electrode (10) and a second varistor electrode (11) that are positioned on either side of the varistor body, the varistor body being able to rise in temperature when the voltage applied across the first and the second varistor electrodes exceeds a voltage threshold;
- making a first electrical connection between the first conductive tab and the first varistor electrode,
- making a second electrical connection between the first discharge tube electrode and the second varistor electrode,
- making a third electrical connection between the second discharge tube electrode and the second conductive tab,
- one of the first and second electrical connections being made via the thermal disconnector (3);
the temperature-sensitive element of the thermal disconnector (3) being a metal connector (13) having a melting point equal to or less than a thermal safety temperature threshold for the varistor,
- soldering a first end of the metal connector (13) to the second varistor electrode,
- arranging an insulator (14) on the component, the insulator (14) being arranged on a surface of the first varistor electrode (10) such that a second end of the metal connector does not make contact with the surface of the first varistor electrode.

9. Method for manufacturing an integrated component for protecting against transient overvoltages, including:
• providing a first and a second conductive tab (15, 16), each of which is able to be mounted on an electrical circuit;
• providing a gas discharge tube (4) including a first discharge tube electrode, a second discharge tube electrode and a discharge tube body arranged between the first and the second discharge tube electrodes, the body of the discharge tube being able to rise in temperature when an electric current flows through it;
• providing a thermal disconnector (3) equipped with a temperature-sensitive element designed to provide an electrical connection in an initial state and to interrupt said electrical connection when it is subjected to a temperature greater than a threshold;
• providing a varistor (2) including:
- a varistor body (9),
- a first varistor electrode (10) and a second varistor electrode (11) that are positioned on either side of the varistor body, the varistor body being able to rise in temperature when the voltage applied across the first and the second varistor electrodes exceeds a voltage threshold;
- making a first electrical connection between the first conductive tab and the first varistor electrode,
- making a second electrical connection between the first discharge tube electrode and the second varistor electrode,
- making a third electrical connection between the second discharge tube electrode and the second conductive tab,
- one of the first and second electrical connections being made via the thermal disconnector (3);
the temperature-sensitive element of the thermal disconnector (3) being a metal connector (13) having a melting point equal to or less than a thermal safety temperature threshold for the varistor or the discharge tube,
- soldering a first end of the metal connector (13) to the first varistor electrode,
- arranging an insulator (14) on the component, the insulator (14) being arranged on a surface of the second varistor electrode (10) such that a second end of the metal connector does not make contact with the surface of the second varistor electrode.
